# EUROPEAN PATENT APPLICATION

(11) **EP 4 057 417 A1**
(43) Date of publication of application: **14.09.2022**
(21) Application number: 21818193.1
(22) Date of filing: 02.04.2021
(51) Int. Cl.: H01M 10/42, H01M 50/20, H01M 50/24, H05K 9/00, H01Q 1/22, H01P 3/12

(54) **BATTERY PACK HAVING OPTIMIZATION STRUCTURE FOR WIRELESS COMMUNICATION, AND VEHICLE COMPRISING SAME**

(30) Priority: 02.06.2020 KR 20200066573
(71) Applicant: LG Energy Solution, Ltd., Seoul 07335 (KR)
(72) Inventor: HWANG, Ji-Won, Daejeon 34122 (KR)
(74) Representative: Plasseraud IP
(86) International application number: PCT/KR2021/004169
(87) International publication number: WO 2021/246633

(57) **Abstract**

Disclosed is a battery pack, which includes a pack case; a plurality of battery modules mounted to the pack case; a plurality of slave modules respectively mounted to the battery modules one by one to monitor a state of the battery module, each slave module having a slave antenna for wireless communication; a master module configured to integrally manage the state of the battery modules based on information obtained from the plurality of slave modules and have a master antenna for wireless communication; and a waveguide installed inside the pack case to form a wireless communication path between the plurality of slave modules and the master module.

## Description

### TECHNICAL FIELD

The present disclosure relates to a battery pack, and more particularly, to a battery pack capable of enhancing reliability of wireless communication by controlling a transmission path of a wireless signal in a battery pack having a wireless control system including a master module and a plurality of slave modules, and a vehicle including the battery pack.

The present application claims priority to Korean Patent Application No. 10-2020-0066573 filed on June 2, 2020, in the Republic of Korea, the disclosures of which are incorporated herein by reference.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

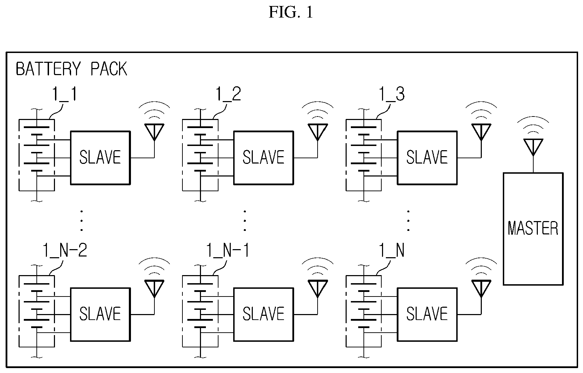

A battery pack for a high-capacity and high-voltage device, such as an electric vehicle, typically includes a plurality of battery modules connected in series with each other. In order to efficiently manage the state of the plurality of battery modules, a wireless control system having a multi slave system is disclosed. The wireless control system having a multi slave system includes, as shown in FIG. 1, a plurality of slave modules for monitoring the state of each battery module (1_1 to 1_N) and a master module for integrally controlling the state of the entire battery pack based on the information of each slave module.

However, when the master module and the plurality of slave modules perform wireless communication with each other, the wireless connection between the master module and at least one slave module may be undesirably cut off due to the influence of external noise, so a solution thereto is being sought.

### DISCLOSURE

### Technical Problem

The present disclosure is designed to solve the problems of the related art, and therefore the present disclosure is directed to providing a battery pack, which may control a transmission path of a wireless signal between a master module and a plurality of slave modules and block external noise by utilizing a structure inside the battery pack as a waveguide, and a vehicle including the battery pack.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

Various embodiments of the present disclosure to accomplish the object are as follows.

In an aspect of the present disclosure, there is provided a battery pack, comprising: a pack case; a plurality of battery modules mounted to the pack case; a plurality of slave modules respectively mounted to the battery modules one by one to monitor a state of the battery module, each slave module having a slave antenna for wireless communication; a master module configured to integrally manage the state of the battery modules based on information obtained from the plurality of slave modules and have a master antenna for wireless communication; and a waveguide installed inside the pack case to form a wireless communication path between the plurality of slave modules and the master module.

The waveguide may include a body portion provided in a hollow tube shape; a slave docking portion having one side communicating with the body portion and the other side provided in surface contact with the slave module; and a master docking portion having one side communicating with the body portion and the other side provided in surface contact with the master module.

The body portion may extend across an inner space of the pack case and the body portion has one end fixedly coupled to one side inner wall of the pack case and the other end fixedly coupled to the other side inner wall of the pack case so that support the pack case.

The slave docking portion may be provided in plural, and the plurality of slave docking portions may be positioned at opposite sides based on the body portion in pairs and arranged at predetermined intervals along an extension direction of the body portion.

The slave docking portion or the master docking portion may include an outer opening provided to cover a location of the slave antenna in the slave module or a location of the master antenna in the master module; a flange formed to expand along a periphery of the outer opening; and a shield gasket having an external electromagnetic wave shielding function and interposed in the flange.

The shield gasket may be prepared as any one of a wire mesh gasket and an external electromagnetic wave absorbing sponge formed by coating a soft foam with an external electromagnetic wave absorbing material.

The slave module and the master module may include a module cover for forming an appearance thereof, and the module cover may be made of a radio wave shielding material or coated with a radio wave shielding material, except for a portion where the slave antenna or the master antenna is positioned.

The battery pack may further comprise a reflection plate provided inside the body portion and configured to open and close an inner opening of the slave docking portion that corresponds to a portion communicating with the body portion.

The reflection plate may include a rotary shaft at an inner surface of the body portion and is configured to rotate based on the rotary shaft so that a rotation angle is adjustable.

The pack case may include a pack tray on which the plurality of battery modules are placed; and a pack cover coupled with the pack tray to cover an upper portion of the plurality of battery modules.

The battery pack may further comprise a wave absorber provided at an inner surface of the pack cover.

The waveguide may be installed at a bottom surface of the pack tray along a center line of the pack tray, and the plurality of battery modules may be disposed to face each other based on the waveguide.

The waveguide may further include a base frame formed below the body portion to have a greater width than the body portion and fixedly coupled to a bottom surface of the pack tray, and the battery modules may be fixed to a top surface of the base frame by bolting.

In another aspect of the present disclosure, there is also provided a vehicle, comprising the battery pack described above.

### Advantageous Effects

The battery pack according to the present disclosure gives the following effects.

By controlling the transmission path of a wireless signal through the waveguide provided in the battery pack, it is possible to secure high reliability of communication between the master module and the plurality of slave modules.

In addition, the waveguide may be utilized as a structure for reinforcing the strength of the pack case or mounting the battery module. The waveguide according to the present disclosure also functions as a cross beam of a conventional battery pack, and thus the volume ratio of the battery pack does not decrease due to the addition of the waveguide.

The effects of the present disclosure are not limited to the above, and effects not mentioned herein may be clearly understood from the present specification and the accompanying drawings by those skilled in the art.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram exemplarily showing a configuration of a battery pack including a wireless control system according to the prior art.
FIG. 2 is a diagram schematically showing an inner configuration of a battery pack according to an embodiment of the present disclosure.
FIG. 3 is a diagram schematically showing a cross section of the battery pack according to an embodiment of the present disclosure.
FIG. 4 is a perspective view schematically showing a waveguide according to an embodiment of the present disclosure.
FIG. 5 is a perspective view schematically showing an example where a battery module is installed at the waveguide of FIG. 4.
FIG. 6 is an enlarged view showing the slave docking portion of FIG. 4.
FIG. 7 is a diagram corresponding to FIG. 6 to show a modified example of a shield gasket.
FIGS. 8 and 9 are schematical sectional views showing a state before and after the waveguide according to an embodiment of the present disclosure is connected to a slave module.
FIG. 10 is a diagram schematically showing an inner configuration of a waveguide according to another embodiment of the present disclosure.
FIG. 11 is a diagram schematically showing a vehicle of the present disclosure.

### BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation. Therefore, the description proposed herein is just a preferable example for the purpose of illustrations only, not intended to limit the scope of the disclosure, so it should be understood that other equivalents and modifications could be made thereto without departing from the scope of the disclosure.

The embodiments disclosed herein are provided for more perfect explanation of the present disclosure, and thus the shape, size and the like of components may be exaggerated, omitted or simplified in the drawings for better understanding. Thus, the size and ratio of components in the drawings do not wholly reflect the actual size and ratio.

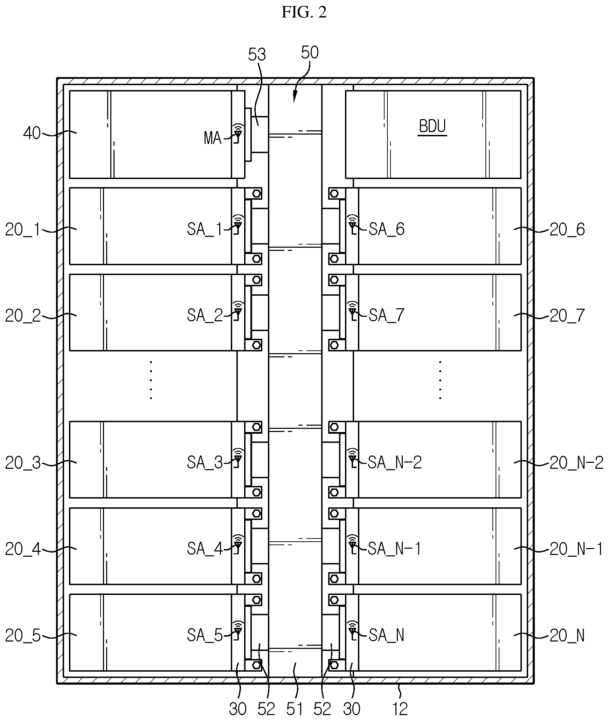

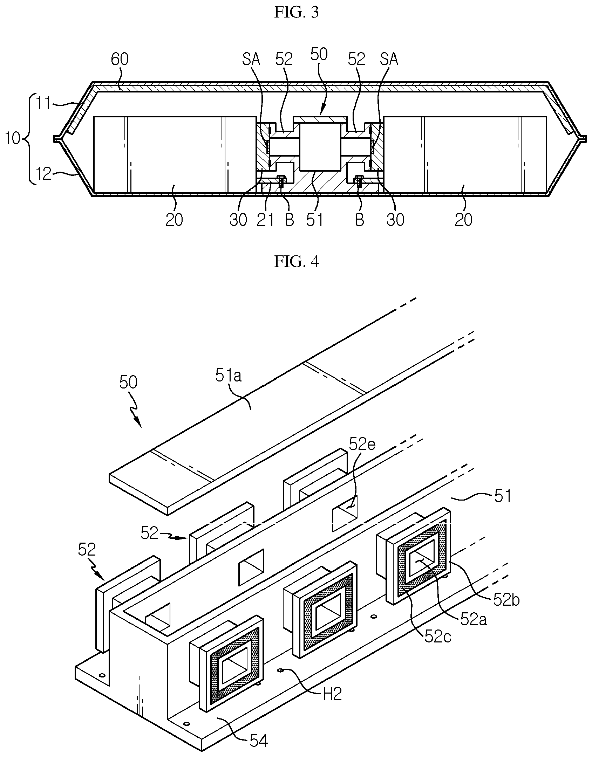

FIG. 2 is a diagram schematically showing an inner configuration of a battery pack according to an embodiment of the present disclosure, and FIG. 3 is a diagram schematically showing a cross section of the battery pack according to an embodiment of the present disclosure.

Referring to FIGS. 2 and 3, a battery pack according to an embodiment of the present disclosure includes a pack case 10, a plurality of battery modules 20, a plurality of slave modules 30, a master module 40 and a waveguide 50.

The pack case 10 includes a pack tray 12 that provides a space for placing the battery modules 20, and a pack cover 11 coupled to a top end of the pack tray 12 to cover an upper portion of the pack tray 12.

The pack tray 12 may include a bottom plate formed in a wide plate shape to accommodate the battery modules 20, the master module 40, and a battery disconnection unit (BDU), and the like, and a side plate that forms a wall along an edge of the bottom plate, so that an upper portion thereof is opened.

Here, the master module 40 is a component that monitors the battery modules 20 in real time and diagnoses, estimates and manages the state of each battery module 20. The master module 40 may be referred to as a BMS (Battery Management System) in the art. In addition, the battery disconnection unit is one of power control components, which includes a relay, a current sensor, a resistor, and the like, and generally refers to a component that connects or disconnects power between a battery and a load.

The pack cover 11 may be coupled to the top end of the pack tray 12 by bonding, hooking, bolting, or the like along a top line of the side plate and may be provided to cover the upper portion of the battery modules 20. The pack cover 11 may be preferably made of a rigid metal material such as steel to protect internal components from the outside. A gasket (not shown) may be further added to the contact area between the pack tray 12 and the pack cover 11 for airtightness.

In particular, the pack cover 11 of this embodiment includes a wave absorber 60 on an inner surface thereof, as shown in FIG. 2. Here, the wave absorber 60 refers to a material that does not generate a reflected wave by absorbing an incident radio wave and converting it into heat. For example, the wave absorber 60 may be manufactured in a sheet form in which a resin and magnetic powder are mixed, and may be attached to an inner surface of the pack cover 11.

If the wave absorber 60 is attached to the inner surface of the pack cover 11 as above, the radio wave transmitting a wireless signal is not reflected by the pack cover 11, and thus it is possible to minimize the effect caused by multipath fading and the effect on other devices by being reflected to the outside.

As an alternative to the sheet, a radio wave absorbing paint may be used. In other words, it is possible to achieve the same effect as attaching the sheet by thickly coating the radio wave absorbing paint on the inner surface of the pack cover 11.

The plurality of battery modules 20 are connected to each other in series or in series and parallel, and each battery module 20 includes at least one battery cell (not shown). For the purpose of distinguishing the plurality of battery modules 20, symbols 20_1 to 20_N (N is a natural number of 2 or above) are given to the plurality of battery modules 20 in FIG. 2.

The battery cell may employ any one of a pouch-type secondary battery, a rectangular secondary battery, and a cylindrical secondary battery.

The slave modules 30 may be mounted to a front surface of the battery module 20, each for each battery module 20, and the slave module 30 is a component that monitors and manages the state of the corresponding battery module 20. The slave module 30 may be referred to as a slave BMS (Battery Module System) in the art. Typically, the slave module 30 is mechanically and electrically connected to the battery module 20 and is provided in an integrated form at one side of the battery module 20. Therefore, the number of slave modules 30 is equal to the number of the plurality of battery modules 20.

Each slave module 30 may include a sensing unit (not shown), a wireless communication circuit (not shown), a slave antenna SA, and a slave control unit (not shown).

The sensing unit may include a voltage measuring circuit, a temperature sensor, and a current sensor.

The voltage measuring circuit measures a module voltage of the battery module 20. The module voltage is a voltage applied to both terminals of the battery module 20. The voltage measuring circuit may further measure a cell voltage of each battery cell included in the battery module 20. The cell voltage is a voltage applied to both terminals of the battery cell. The voltage measuring circuit sends a voltage signal representing the module voltage and the cell voltage to the slave control unit.

The temperature sensor is disposed within a predetermined distance from the battery module 20 and transmits a temperature signal indicating the temperature of the battery module 20 to the slave control unit.

The current sensor is installed on a charging/discharging current path of the battery pack, measures a current flowing during charging/discharging of the battery pack, and transmits a current signal indicating the measured current to the slave control unit.

The wireless communication circuit may be implemented using an RF SoC (System on Chip) in hardware and is connected to the slave control unit and the slave antenna SA. For the purpose of distinguishing the slave antenna SA provided to each slave module 30, codes SA_1 to SA_N (N is a natural number of 2 or above) are assigned to the place where the slave antenna SA is located in FIG. 2. The wireless communication circuit may wirelessly transmit data to the master module 40 or wirelessly receive data from the master module 40 through the slave antenna SA. In addition, if a certain signal is received through the slave antenna SA, the wireless communication circuit may measure the signal strength of the received signal.

The slave control unit may be operatively coupled to the sensing unit and the wireless communication circuit and configured to individually control the operation of each of them.

The master module 40 is a component that integrally controls the battery pack, and is configured to communicate with an external main controller (e.g., an ECU of an electric vehicle) through a wired network such as a CAN (Control Area Network).

In addition, the master module 40 includes a wireless communication circuit (not shown), a master control unit (not shown) and a master antenna MA, and is configured to make wireless communication with each slave module 30 through the master antenna MA.

The wireless communication circuit is configured to wirelessly transmit a command packet to the slave module 30 through the master antenna MA. In addition, the wireless communication circuit is configured to receive a response packet from the slave module 30 through the master antenna MA.

Each of the plurality of slave modules 30 performs wireless communication with the master module 40 by using its ID allocated in advance, and the master module 40 stores the ID allocated in advance to the plurality of slaves. The ID is identification information for distinguishing the plurality of slave modules.

Based on battery information obtained from the slave module 30, the master module 40 may calculate SOC (State Of Charge), SOH (State Of Health), or the like of each battery module 20 or determine whether each battery module 20 is in an overvoltage, undervoltage, overcharge or overdischarge state.

The master control unit is operatively connected to the wireless communication circuit. The master control unit may determine a requesting item for at least one of the plurality of slave modules based on a signal received through the master antenna MA, and wirelessly transmit a command packet including data representing the requesting item to at least one of the plurality of slave modules 30.

Meanwhile, the battery pack according to an embodiment of the present disclosure includes a waveguide 50 that forms a wireless communication path so that the path of wireless communication between the plurality of slave modules 30 and the master module 40 may be controlled.

Hereinafter, the configuration and operation of the waveguide 50 will be described in detail with reference to FIGS. 4 to 9 along with FIGS. 2 and 3.

The waveguide 50 plays a role of transmitting radio waves while minimizing the energy loss of radio waves and the interference of external noise between an antenna and a receiver. The waveguide 50 may be manufactured in the form of a hollow metal tube with a rectangular or circular cross section, and the size of the waveguide 50 may be variously determined depending on the wireless communication frequency.

The waveguide 50 allows electromagnetic waves to move along the limited inner space of the waveguide 50 and may reduce energy loss of electromagnetic waves since current does not flow inside the waveguide 50. In addition, since the inside of the waveguide 50 is filled with air, dielectric loss is also small.

In the present disclosure, the waveguide 50 is used as a wireless transmission path between each slave module 30 and the master module 40. For this purpose, the cross beam in the pack case 10, which is usually applied to prevent distortion of the pack case 10 when an external impact is applied, is configured with the waveguide 50. Therefore, the waveguide 50 of this embodiment plays two roles as a wireless signal transmission path and a structure for reinforcing the strength of the pack case 10.

As shown in FIG. 2, the waveguide 50 of this embodiment may be installed at a bottom surface of the pack tray 12 so as to extend across a center region of the pack case 10 to bisect the inner space of the pack case 10. In addition, one end and the other end of the waveguide 50 may be fixedly coupled to one side inner wall and the other side inner wall of the pack tray 12, respectively. Since both walls of the pack case 10 may be supported by the waveguide 50, even if there is an external impact, the pack case 10 may not be easily twisted or deformed.

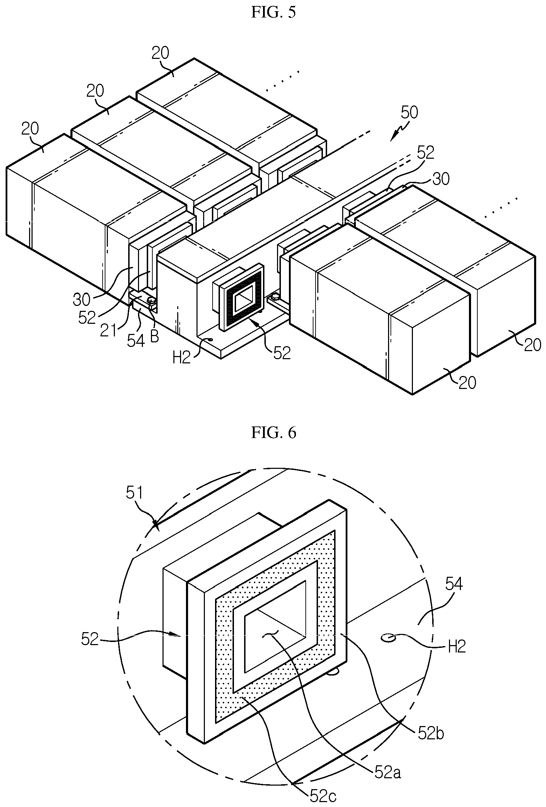

The waveguide 50 includes a body portion 51, a slave docking portion 52, a master docking portion 53 and a base frame 54, as shown in FIGS. 4 and 5.

The body portion 51 is provided in the form of a hollow rectangular metal tube. The body portion 51 may be provided to open and close the upper portion. For example, the body portion 51 may include a body having an open upper portion and an upper plate 51a capable of covering the body. The body portion 51 of this configuration has an advantage that, when dust or foreign substance is introduced into the body portion 51, the interior of the body portion 51 may be easily cleaned by separating the upper plate 51a.

The slave docking portion 52 is a part connected to the slave module 30 of each battery module 20, and has one side communicating with the interior of the body portion 51 and the other side provided in surface contact with the slave module 30.

The slave docking portion 52 includes an outer opening 52a provided to protrude from an outer surface of the body portion 51, a flange 52b formed to expand along a periphery of the outer opening 52a, an electromagnetic wave shield gasket 52c interposed in the flange 52b, and an inner opening 52e.

The outer opening 52a is provided in a size corresponding to the area of a region of the slave module 30 where the slave antenna SA is located and covers the region of the slave antenna SA so that a radio wave signal may be transmitted most efficiently into the waveguide 50.

The flange 52b is a part in surface contact with the module cover that forms an appearance of the slave module 30. By increasing the contact area with the module cover by using the flange 52b, it is possible to prevent the module cover stabbed or scratched and to alleviate the impact that may be applied to the slave module 30.

In order to minimize the interference of external radio waves, an outer region of a portion of the module cover that makes contact with the flange 52b may be made of a metal having an electromagnetic wave shielding function or a non-metallic material having a sheet or paint with an electromagnetic wave shielding function on the surface thereof. That is, the module cover may be made of a radio wave shielding material or coated with a radio wave shielding material, except for a portion where the slave antenna SA is located therein.

Referring to FIG. 6, the electromagnetic wave shield gasket 52c is to eliminate the interference of external electromagnetic wave that may be introduced into the waveguide 50, and an external electromagnetic wave absorbing sponge specially prepared by coating a soft foam such as a polyurethane foam with an external electromagnetic wave absorbing material may be applied. The external electromagnetic wave absorbing sponge may be attached to a surface of the flange 52b by bonding or the like. Since the external electromagnetic wave absorbing sponge has excellent flexibility and elasticity due to its characteristics, it is also possible to prevent scratches when the flange 52b contacts the module cover.

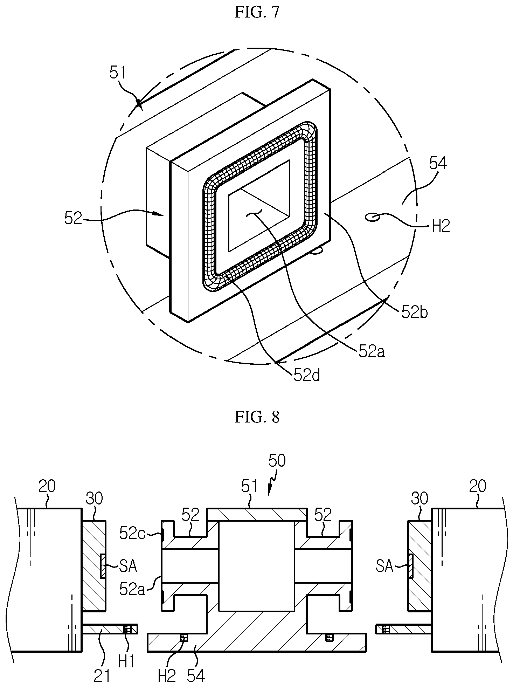

As an alternative to the external electromagnetic wave absorbing sponge, a wire mesh shield gasket 52d as shown in FIG. 7 may be employed. The wire mesh shield gasket 52d is highly flexible by weaving metal wires in a knitting method and has excellent electromagnetic wave shielding effect due to excellent contact with a counterpart. Silicone elastomer, urethane sponge, or the lime may be inserted as a core of the wire mesh.

The wire mesh shield gasket 52d may be attached to the surface of the flange 52b with an adhesive tape or, as a modified example, the wire mesh shield gasket 52d may be interposed in the flange 52b by providing a groove at the flange 52b and inserting it into the groove and fixing thereto.

The master docking portion 53 has substantially the same structure as the slave docking portion 52 described above, but is different in that the connection target is the master module 40. That is, the master docking portion 53 (see FIG. 2) is provided so that one side communicates with the body portion 51 and the other side is in surface contact with the master module 40. In addition, the outer opening 52a of the master docking portion 53 may be provided in a size capable of covering the location of the master antenna MA in the master module 40.

The base frame 54 is a part fixedly coupled to the bottom surface of the pack tray 12 and is located below the body portion 51 to have a larger width than the body portion 51. The base frame 54 may be coupled to the bottom surface of the pack tray 12 by welding or bolting.

Since the base frame 54 is formed to be wider than the body portion 51, the base frame 54 may be used as a place for mounting the battery modules 20. As shown in FIGS. 3 to 5, each battery module 20 may be fixed to the waveguide 50 by coupling the mounting bracket 21 disposed at a top surface of the base frame 54 to the base frame 54 with a bolt B. In this case, the slave module 30 of each battery module 20 may be accurately aligned with the slave docking portion 52 of the corresponding waveguide 50, and the direction thereof may not be changed even if there is an external shock after alignment.

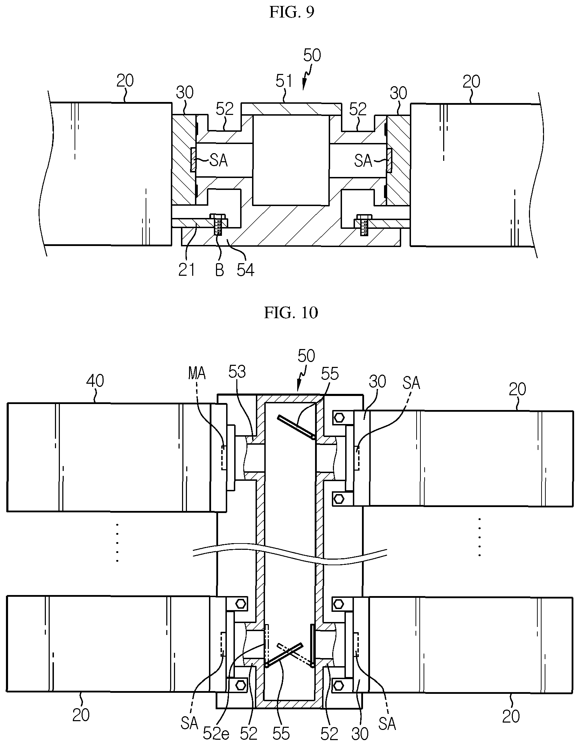

Next, a process of connecting each slave module 30 and the master module 40 to the waveguide 50 will be described with reference to FIGS. 8 and 9.

The waveguide 50 is placed along a center line of the pack tray 12. In addition, as shown in FIG. 8, the battery modules 20 are disposed to symmetrically face each other based on the waveguide 50 in pairs. As described above, each slave module 30 is mounted to each battery module 20, and the direction in which the pair of battery modules 20 face each other is the direction in which each slave module 30 faces the waveguide 50.

After that, as shown in FIG. 9, in each slave module 30, the region of the slave antenna SA and the outer opening 52a of the slave docking portion 52 are matched. At this time, if a hole H1 of the mounting bracket 21 of the battery module 20 and a hole H2 of the top surface of the base frame 54 of the waveguide 50 are aligned vertically, it may be regarded that the waveguide 50 and the slave module 30 are aligned correctly. In this state, the battery module 20 is fixed to the waveguide 50 by fastening the mounting bracket 51 to the base frame 54.

By fixing each battery module 20 to the waveguide 50 along the extension direction of the waveguide 50 in the same pattern as above, each slave antenna SA faces the inside of each slave docking portion 52 of the waveguide 50. In the case of the master module 40, like the slave module 30, the master antenna MA is provided to face the inside of the master docking portion 53 of the waveguide 50.

By the configuration according to an embodiment of the present disclosure as described above, the radio wave transmission path of the wireless signal between each slave module 30 and the master module 40 may be limited within the waveguide 50, and the interference of external radio wave may be minimized, thereby increasing the reliability of wireless communication between each slave module 30 and the master module 40.

FIG. 10 is a diagram schematically showing an inner configuration of a waveguide 50 according to another embodiment of the present disclosure.

Next, another embodiment of the present disclosure will be described with reference to FIG. 10. The same reference numerals as those in the former embodiment denote the same components, and the same components will not be described again, and different features from the former embodiment will be mainly described.

The battery pack according to another embodiment of the present disclosure further includes a reflection plate 55 inside the waveguide 50, compared with the battery pack of the former embodiment.

The reflection plate 55 is provided inside the body portion 51 to open and close the inner opening 52e of each slave docking portion 52. For example, the reflection plate 55 is formed with a size enough to cover the inner opening 52e and may include a rotary shaft around the inner opening 52e on the inner surface of the body portion 51 to rotate in a range of 0 degrees to 180 degrees. The rotation angle of the reflection plate 55 may be precisely controlled by connecting a servo motor (not shown) to the rotary shaft of the reflection plate 55. The servo motor is wired or wirelessly connected to the control unit of each slave module 30 or the control unit of the master module 40 and may be operated according to a command of the control unit.

According to the configuration of another embodiment of the present disclosure, the transmission path of the wireless signal may be more effectively controlled, compared to the former embodiment. For example, as shown in FIG. 10, the communication path of the slave module 30 that is not communicating with the master module 40 may be shielded by the reflection plate 55 to minimize radio wave interference. Also, the communication path of each slave module 30 communicating with the master module 40 may be more effectively controlled by the reflection plate 55. For example, the master module 40 or each slave module 30 detects the signal strength through a RSSI (Received Signal Strength Indication), and finds an optimal opening angle of the reflection plate 55 when the signal is transmitted to and received from the master antenna MA smoothest for each slave antenna SA. The reflection plate 55 is adjusted according to the optimum opening angle for each slave module 30 so that the signal strength may be maintained above an appropriate level.

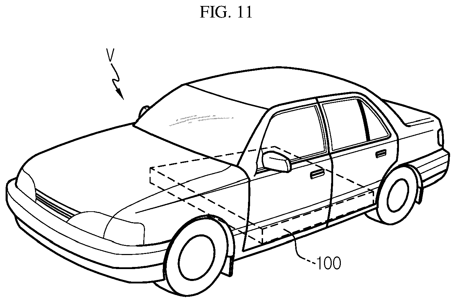

FIG. 11 is a diagram schematically showing a vehicle of the present disclosure.

The battery pack 100 according to the present disclosure may be included as a power energy source for a vehicle V, such as an electric vehicle or a hybrid electric vehicle. That is, the vehicle V according to the present disclosure may include the battery pack 100 described above.

The battery pack 100 may be mounted to the electric vehicle V to supply an electric power required to drive an electric motor of the electric vehicle V. In addition, the master module of the battery pack 100 may communicate with an ECU (Electronic Control Unit) of an external electric vehicle through a wired network such as a CAN (Control Area Network).

In addition to the vehicle V, of course, the battery pack 100 may be provided to other devices, instruments, facilities, or the like, such as an energy storage system using a secondary battery.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Meanwhile, when the terms indicating up, down, left and right directions are used in the specification, it is obvious to those skilled in the art that these merely represent relative locations for convenience in explanation and may vary based on a location of an observer or an object to be observed.

## Claims

1. A battery pack, comprising:
a pack case;
a plurality of battery modules installed in the pack case;
a plurality of slave modules respectively mounted to the battery modules one by one to monitor a state of the battery module, each slave module having a slave antenna for wireless communication;
a master module configured to integrally manage the state of the battery modules based on information obtained from the plurality of slave modules and have a master antenna for wireless communication; and
a waveguide installed inside the pack case to form a wireless communication path between the plurality of slave modules and the master module.

2. The battery pack according to claim 1,
wherein the waveguide includes:
a body portion provided in a hollow tube shape;
a slave docking portion having one side communicating with the body portion and the other side provided in surface contact with the slave module; and
a master docking portion having one side communicating with the body portion and the other side provided in surface contact with the master module.

3. The battery pack according to claim 2,
wherein the body portion extends across an inner space of the pack case and the body portion has one end fixedly coupled to one side inner wall of the pack case and the other end fixedly coupled to the other side inner wall of the pack case so that support the pack case.

4. The battery pack according to claim 2,
wherein the slave docking portion is provided in plural, and the plurality of slave docking portions are positioned at opposite sides based on the body portion in pairs and arranged at predetermined intervals along an extension direction of the body portion.

5. The battery pack according to claim 2,
wherein the slave docking portion or the master docking portion includes:
an outer opening provided to cover a location of the slave antenna in the slave module or a location of the master antenna in the master module;
a flange formed to expand along a periphery of the outer opening; and
a shield gasket having an external electromagnetic wave shielding function and interposed in the flange.

6. The battery pack according to claim 5,
wherein the shield gasket is prepared as any one of a wire mesh gasket and an external electromagnetic wave absorbing sponge formed by coating a soft foam with an external electromagnetic wave absorbing material.

7. The battery pack according to claim 5,
wherein the slave module and the master module include a module cover, and
the module cover is made of a radio wave shielding material or coated with a radio wave shielding material, except for a portion where the slave antenna or the master antenna is positioned.

8. The battery pack according to claim 2, further comprising:
a reflection plate provided inside the body portion and configured to open and close an inner opening of the slave docking portion.

9. The battery pack according to claim 8,
wherein the reflection plate includes a rotary shaft at an inner surface of the body portion and is configured to rotate based on the rotary shaft so that a rotation angle is adjustable.

10. The battery pack according to claim 2,
wherein the pack case includes:
a pack tray on which the plurality of battery modules are placed; and
a pack cover coupled with the pack tray to cover an upper portion of the plurality of battery modules.

11. The battery pack according to claim 10, further comprising:
a wave absorber provided at an inner surface of the pack cover.

12. The battery pack according to claim 10,
wherein the waveguide is installed at a bottom surface of the pack tray along a center line of the pack tray, and
the plurality of battery modules are disposed to face each other based on the waveguide.

13. The battery pack according to claim 10,
wherein the waveguide further includes a base frame formed below the body portion to have a greater width than the body portion and fixedly coupled to a bottom surface of the pack tray, and
the battery modules are fixed to a top surface of the base frame by bolting.

14. A vehicle, comprising the battery pack according to any one of claims 1 to 13.
